# EUROPEAN PATENT APPLICATION

(11) **EP 0 608 674 A1**
(43) Date of publication of application: **03.08.1994**
(21) Application number: 93870013.5
(22) Date of filing: 26.01.1993
(51) Int. Cl.: H01L 33/00

(54) **InAsSb light emitting diodes**

(71) Applicant: INTERUNIVERSITAIR MICROELEKTRONICA CENTRUM VZW, B-3001 Leuven (BE)
(72) Inventor: Dobbelaere, Wim, B-9400 Ninove (BE); Borghs, Gustaaf Regina, B-3010 Kessel-Lo (BE)
(74) Representative: Vanderperre, Robert

(57) **Abstract**

A light emitting diode characterized by a doped p-n junction grown on a semiconductor substrate, said doped p-n junction consisting of a bulk InAs₁₋ₓSbₓ layer doped with beryllium as p-doping element and silicum as n-doping element, wherein the compositional parameter x is set to a value comprised in the range from 0 to 1 thereby to define the wavelength of the emitted light when the structure is activated.

## Description

The present invention relates to the manufacture of InAs₁₋ₓSbₓ light emitting diodes.

Infrared photodiodes are known which are made from ternary InAs₁₋ₓSbₓ material grown on GaAs and Si substrates and the high-detectivity of InAs_{0.85}Sb_{0.15} diodes has been demonstrated (Dobbelaere W., De Boeck J., Herremans P., Mertens R., Borghs G., Luyten W. and Van Landuyt J. : InAsSb Infrared Photodiodes Grown on GaAs and GaAs-coated Si by Molecular Beam Epitaxy, Appl. Phys. Lett., 1992, 60, pp. 3256-3258).

The inventors have now found that besides its use as photodetectors, the ternary InAs₁₋ₓSbₓ material can also be grown in such a way as to realize devices for use as light emitting sources.

According to an object of this invention there is provided InAs₁₋ₓSbₓ light emitting diodes (LEDs) comprising a doped p-n junction grown on a semiconductor substrate, said doped p-n junction consisting of a bulk InAs₁₋ₓSbₓ layer doped with beryllium as p-doping element and silicium as n-doping element, wherein the compositional parameter x is set to a value comprised in the range from 0 to 1 thereby to define the wave-length of the emitted light when the structure is activated.

Advantageously, the bulk InAs₁₋ₓSbₓ layer comprises a highly p+doped back layer between the substrate and the p-doped layer of the p-n diode junction and a highly n+doped cap layer above the n-doped layer of the p-n diode junction, thus resulting in a very low metallization contact resistance.

InAs₁₋ₓSbₓ LEDs in accordance with the invention can be used to advantage as light sources in various applications, e.g. in infrared or opto-acoustical gas sensors, and in telecommunication for driving infrared fibers. In the particular application to infrared gas sensors, InAs₁₋ₓSbₓ LEDs have the advantage over the conventional black body light sources that their light emission peak can be made to coincide with the absorption resonances of the gas to be sensed whereby an optimum signal-to-noise ratio can be obtained.

When used in driving infrared fibers, InAs₁₋ₓSbₓ LEDs have the advantage that the higher wavelength of the emitted light makes it possible to limit the scattering loss, whereby light signals can be transmitted over a longer distance.

Another object of this invention is to provide InAs₁₋ₓSbₓ lasers using InAs₁₋ₓSbₓ light emitting diodes in accordance with the invention.

These and other advantages and features of the invention will become apparent from the following description, reference being made to the accompanying drawings.

In the drawings :
Fig. 1 is a schematic cross sectional view of a light emitting diode structure according to the invention illustrating a typical doping scheme.
Fig. 2 shows the light emission spectrum of a LED according to the invention with different Sb-content, grown on GaAs (solid line) and Si (dashed line) substrate.
Fig. 3 shows the light emission spectrum of a LED grown on GaAs substrate according to the invention at different temperatures.
Fig. 4 shows the temperature dependence of the external quantum efficiency of a LED according to the invention for a 200 mA current.
Fig. 5 schematically illustrates the use of a LED according to the invention in a CO₂ gas sensor.
Fig. 6 shows the measured light emission spectrum in the application of Fig. 5.
Fig. 7 illustrates the improved emission efficiency of a LED according to the invention provided with three typical heterostructures.

Light emitting diodes in accordance with this invention are made of a doped thick bulk InAs₁₋ₓSbₓ layer grown on GaAs, InAs or Si substrates with a compositional range from x=0 to x=1 and with a doping scheme using beryllium (Be) as p-doping element and silicium (Si) as n-doping element. The inventors have observed that the p-n diode defined above is capable of light emittance at a wavelength which depends on the compositional parameter x as will be seen later herein.

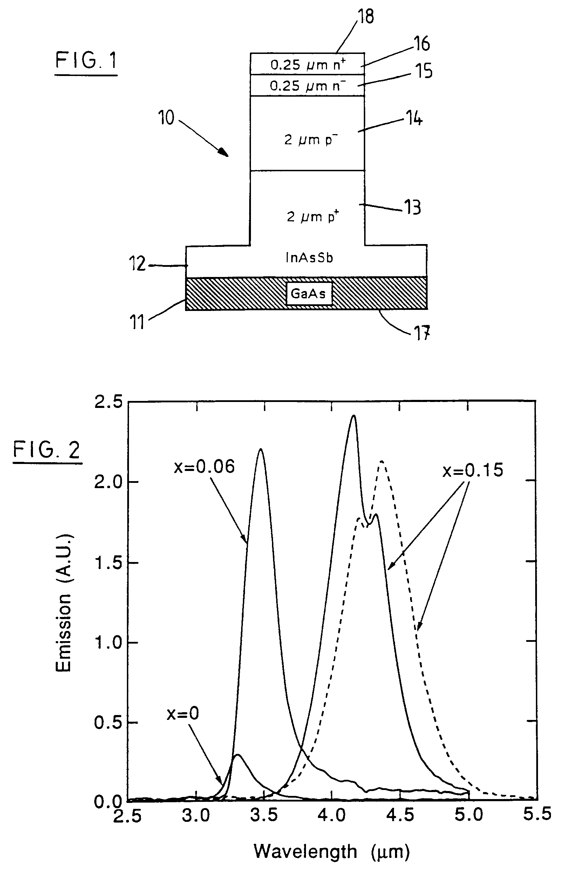

The doped thick bulk InAs₁₋ₓSbₓ layer is grown by molecular beam epitaxy as outlined hereafter. This layer can be grown on GaAs, InAs or Si substrates. When using a Si substrate this may be precoated with a thin GaAs buffer layer or not. Fig. 1 shows an exemplary LED structure grown on a GaAs substrate 11. With a substrate temperature of 490°C, a 1 µm thick InAs nucleation layer is first grown at a standard growth rate of 1 µm/h. A network of dislocations is formed at the InAs/GaAs interface due to large lattice mismatch between InAs and GaAs. A 3 µm thick layer of linearly graded InAs₁₋ₓSbₓ is then grown at a substrate temperature of 450°C which is used to remove the threading dislocations using Sb₄ tetramers from a standard Sb source and As₂ dimers produced by a cracked As cell. The Sb₄ flux is varied linearly between 1.8x10⁻⁸ and 2.7x10⁻⁷ Torr beam equivalent pressure in a time period of 1 hour, requiring a non linear change in the Sb₄ source temperature. During the first 0.25 µm of this epilayer, the substrate temperature has to be lowered gradually to 450°C. The growth is conducted with a p-and n-doping scheme at approximately 10¹⁷ cm⁻³ using berylium Be as p-doping element and silicium Si as n-doping element, resulting in the desired InAs₁₋ₓSbₓ epilayer 10.

A typical p- and n-doping scheme is as follows : 2 µm highly p+doped layer 13 serving to lower the backside series resistance of the diode, 2 µm p-doped (Be) layer 14, 0.25 µm n-doped (Si) layer 15 and 0.25 µm n+doped layer 16 serving as a cap layer that results in a very low metallization contact resistance. The p-n junction occurs at 5 µm from the InAs/GaAs interface. Devices are then fabricated by mesa-etching followed by Ti/Au metallization of the outer faces 17 and 18.

When activated, InAs₁₋ₓSbₓ diode structures are capable of emitting light in the wavelength range from 3 to 5 µm depending on the Sb content of the alloy. Fig. 2 shows the light emittance of InAs₁₋ₓSbₓ LEDs with different Sb contents. The measurements were performed at a temperature of 77 K using a 200 mA activation current. The emitted light was focused into the entrance slit of a monochromator using ZnSe optics and the dispersed light was detected with a liquid nitrogen cooled InSb photodiode. The solid line represents the light emission spectra for diodes grown on GaAs substrate with x=0, 0.06 and 0.15, the dashed line represents the light emission spectra for a diode grown on GaAs-coated Si substrate with x=0.15. It is observed that the spectra shift to longer wavelengths with increasing Sb content as a consequence of the reduction of the bandgap.

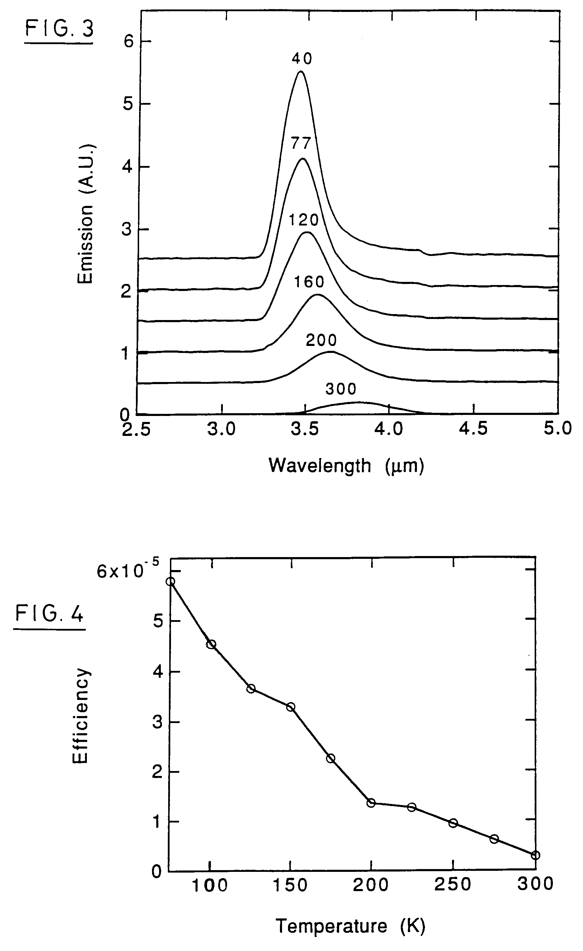

It has also been observed that the light emittance of a LED according to the invention varies with the temperature in use. Fig. 3 shows the temperature dependence of the light emittance for an InAs_{0.94}Sb_{0.06}/GaAs LED device. The lower energy portion of the spectra have the shape of the conduction band density of states while the higher energy portion is determined by the thermal distribution. With increasing temperature, the broadening of the distribution function increases and the spectrum shifts to longer wavelengths, i.e. towards the infrared, due to the temperature dependence of the bandgap. The magnitude of the light emission decreases with increasing temperature as a consequence of a non-radiative recombination phenomenon.

Fig. 4 shows the external quantum efficiency of an LED according to the invention as a function of temperature. The efficiency measurements were calibrated by placing a large area InSb detector in front of a small LED whereby most of the emitted light is caused to impinge the detector. It is seen that the efficiency decreases with increasing temperature due to a non-radiative recombination mechanism.

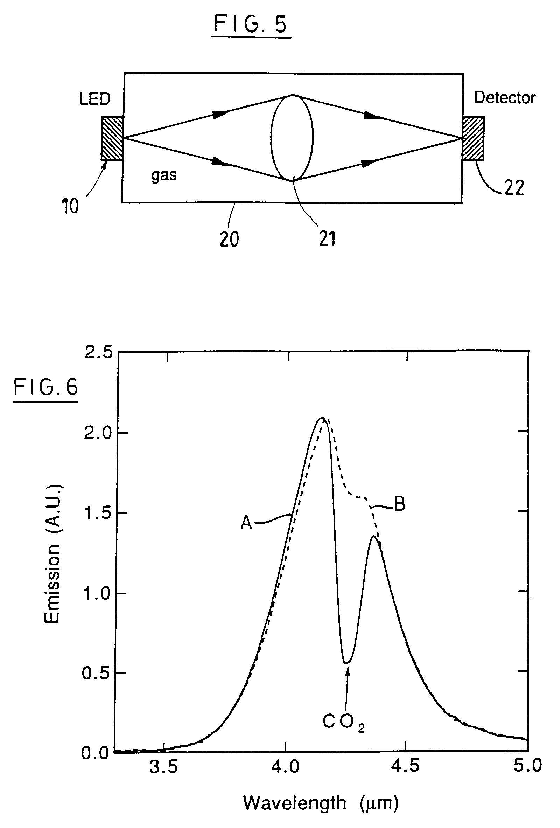

As a consequence of the emission wavelength of a InAs₁₋ₓSbₓ light emitting diode structure according to the invention depending on the alloy concentration parameter x, a wide range of semiconductor structures can be realized for use as light sources to suit various applications. A typical application is using InAs₁₋ₓSbₓ LEDs in infrared gas sensors to operate in the wavelength range from 3 to 9 µm. Referring to Fig. 5, there is schematically shown an InAs₁₋ₓSbₓ LED 10 in use in a CO₂ gas sensor. The light emitted by the LED 10 is directed through a container 20 including a defined quantity of a gas to be sensed and through a lens 21 onto a light detector 22, e.g. a known InSb or HgCdTe detector or an InAs₁₋ₓSbₓ detector.

Fig. 6 shows the light spectrum of an InAs_{0.85}Sb_{0.15} LED as measured by an InSb detector after transmission through air (curve A) and through air containing about 2 % CO₂ (curve B). Curve A shows a dip at 4.3 µm wave-length, caused by CO₂ absorption resonance. This absorption resonance has disappeared from curve B.

The advantage of using a LED according to the invention as a light source over a conventional black body radiator resides in that it can be adjusted such that its light emission peak to coincide with the absorption resonances of the gas to be sensed, whereby an optimum signal-to-noise ratio can be obtained.

InAs₁₋ₓSbₓ light emitting diodes can be used as light sources in opto-acoustical gas sensors as well, thereby replacing conventional broad band frequency emitting sources and filters. The ease of high modulation makes them very suitable to improve the signal-to-noise ratio.

InAs₁₋ₓSbₓ LEDs are suitable to be used to advantage for driving infrared fibers. As compared to known systems, the higher infrared wavelength of LEDs according to the invention makes it possible to limit the scattering losses, whereby the light signals can be transmitted over a longer distance.

InAs₁₋ₓSbₓ light emitting diodes according to the invention can also be used to implement a laser function. To that purpose, an InAs₁₋ₓSbₓ LED is placed in a cavity whereby the emission angle is reduced and the spectral linewidth is narrowed.

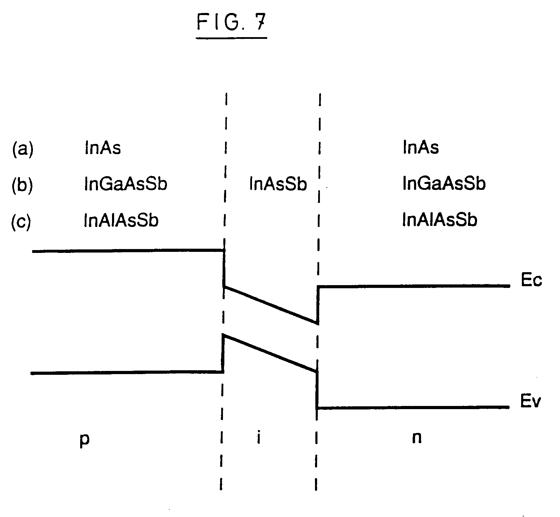

According to a further aspect of the invention, the performance of InAs₁₋ₓSbₓ LED can be improved by providing an undoped layer between the p- and n-doped layers of the diode junction, whereby injection of electrons and holes is increased. Fig. 7 illustrates the improved emission efficiency provided by three typical heterostructures comprising an undoped InAs₁₋ₓSbₓ layer i between the p- and n-doped layers of the diode junction. The three possible cases contemplated here are :
a. InAsInAs₁₋ₓSbₓInAs pseudomorphic
b. InGaSbAsInAs₁₋ₓSbₓInGaAsSb lattice matched
c. InAlAsSbInAs₁₋ₓSbₓInAlAsSb lattice matched.

Although there has been described hereinbefore one particular embodiment in accordance with the invention for the purpose of illustrating the manner in which the invention may be used to advantage, it will be appreciated that the invention is not limited thereto. Accordingly, any and all modifications, variations or equivalent arrangements which may occur to those skilled in the art should be considered to be within the scope of the invention.

## Claims

1. A light emitting diode, characterized by a doped p-n junction grown on a semiconductor substrate, said doped p-n junction consisting of a bulk InAs₁₋ₓSbₓ layer doped with beryllium as p-doping element and silicum as n-doping element, wherein the compositional parameter x is set to a value comprised in the range from 0 to 1 thereby to define the wavelength of the emitted light when the structure is activated.

2. The device according to claim 1, characterized in that the bulk InAs₁₋ₓSbₓ layer further includes a highly p+doped back layer between the substrate and the p-doped layer of said p-n junction and a highly n+doped cap layer above the n-doped layer of said p-n junction.

3. The device according to claim 1 or 2, characterized by further including an undoped InAs₁₋ₓSbₓ layer grown between the p- and n-doped layers of the diode junction.

4. The device according to claim 1, 2 or 3, wherein the opposite outer faces of the device are metallized.

5. The use of a device according to claim 1, 2, 3 or 4 as a light emitting source in an infrared gas sensor.

6. The use of a device according to claim 1, 2, 3 or 4 as a light source in an opto-acoustical gas sensor.

7. The use of a device according to claim 1, 2, 3 or 4, wherein the InAs₁₋ₓSbₓ light emitting diode is placed in a cavity, thereby to achieve the operation of a diode laser.
